Europäisches Patentamt

European Patent Office

Office européen des brevets

(19)

(11) Veröffentlichungsnummer: **0 367 344**

**A2**

(12) # EUROPÄISCHE PATENTANMELDUNG

(21) Anmeldenummer: **89202726.9**

(22) Anmeldetag: **30.10.89**

(51) Int. Cl.⁵· **G01R 33/46**

(30) Priorität: **03.11.88 DE 3837317**

(43) Veröffentlichungstag der Anmeldung:
**09.05.90 Patentblatt 90/19**

(84) Benannte Vertragsstaaten:
**DE FR GB**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB**

(72) Erfinder: **Kunz, Dietmar Wilhelm, Dr.**
**Berliner Strasse 10**
**D-2085 Quickborn(DE)**

(74) Vertreter: **Hartmann, Heinrich, Dipl.-Ing. et al**
**Philips Patentverwaltung GmbH**
**Wendenstrasse 35 Postfach 10 51 49**
**D-2000 Hamburg 1(DE)**

(54) **Kernresonanzspektrokopieverfahren und Anordnung zur Durchfürhrung des Verfahrens.**

(57) Die Erfindung betrifft ein Verfahren, bei dem zur Unterdrückung der Dublettstruktur von wenigstens eine CH-Gruppe in Kohlenstoff und Wasserstoff enthaltenden Verbindungen ein erstes magnetisches Hochfrequenzfeld mit der Larmorfrequenz des Kohlenstoffs erzeugt wird, wonach ein zweites magnetisches Hochfrequenzfeld mit der Larmorfrequenz des Wasserstoffs in der betreffenden CH-Gruppe auf den Untersuchungsbereich einwirkt, und das erzeugte Kernresonanzsignal erfaßt wird sowie eine Anordnung zur Durchführung des Verfahrens. Dabei läßt sich eine Entkopplung mit verringerter Hochfrequenzbelastung dadurch erreichen, daß eine vorgegebene Zeit dt nach dem Ende der Anregung des kohlenstoffs zunächst ein magnetischer Hochfrequenzimpuls der Dauer T und der Amplitude $B_p$ erzeugt wird, daß unmittelbar danach die Amplitude des HF-Feldes auf einen Wert $B_c$ abgesenkt wird und währenddessen das Kernresonanzsignal erfaßt wird, und daß die Parameter dt, Bc und Bp so gewählt sind, daß die durch die J-Kopplung bewirkte Modulation des Kernresonanzsignals gerade verschwindet.

Fig.1

## Kernresonanzspektroskopieverfahren und Anordnung zur Durchführung des Verfahrens

Die Erfindung betrifft ein Kernresonanz-Spektroskopieverfahren, bei dem zur Unterdrückung der Dublettstruktur von wenigstens eine CH-Gruppe in Kohlenstoff und Wasserstoff enthaltenden Verbindungen ein erstes magnetisches Hochfrequenzfeld mit der Larmorfrequenz des Kohlenstoffs erzeugt wird, wonach ein zweites magnetisches Hochfrequenzfeld mit der Larmorfrequenz des Wasserstoffs in der betreffenden CH-Gruppe auf den Untersuchungsbereich einwirkt, und das erzeugte Kernresonanzsignal erfaßt wird. Außerdem bezieht sich die Erfindung auf eine Anordnung zur Durchführung des Verfahrens.

Bei der spektroskopischen Untersuchung von Kohlenstoff und Wasserstoff enthaltenden Verbindungen zeigen die Kohlenstoffspektren (des Isotops $^{13}C$) starke Strukturen, die von den J-Kopplungen der Kohlenstoffatome an die Wasserstoffkerne herrühren. Je nach Orientierung der Kernspins der mit den Kohlenstoffatomen gekoppelten Wasserstoffatome ist das Magnetfeld am Ort des jeweiligen Kohlenstoffatoms mehr oder minder groß, woraus unterschiedliche Larmorfrequenzen bzw. mehrere dicht benachbarte Linien (Multiplett) im Spektrum resultieren.

Es ist unter anderem aus der US-PS 4.470.014 bekannt, daß man diese Multiplettstruktur dadurch reduzieren kann, daß während der Erfassung des Kernresonanzsignals, dessen Frequenz der Larmorfrequenz von Kohlenstoff entspricht, ein magnetisches Hochfrequenzfeld mit der Larmorfrequenz des Wasserstoffs eingestrahlt wird. Durch dieses Hochfrequenzfeld werden während der Messung der Kernresonanz signale die Kernspins der mit den Kohlenstoffatomen gekoppelten Wasserstoffatome ständig hin- und hergekippt, so daß sie im zeitlichen Mittel keinen Einfluß auf das Kohlenstoffatom mehr ausüben.Dieses Verfahren wird als "Entkopplung" bezeichnet und die damit erzeugten Spektren als entkoppelte Spektren.

Voraussetzung dafür ist allerdings, daß das Hochfrequenzmagnetfeld die Wasserstoffkerne, d.h. die Protonen, wesentlich stärker beeinflußt als die J-Kopplung. Wenn die CH-Gruppe, deren Multiplettstruktur unterdrückt werden soll, eine starke J-Kopplung aufweist, erfordert dies sehr starke Hochfrequenzmagnetfelder, so daß es wegen der damit verbundenen Hochfrequenzbelastung nicht möglich ist, derartige Verfahren bei in-vivo-Untersuchungen anzuwenden.

Aufgabe der vorliegenden Erfindung ist es, Dublettstrukturen (die von CH-Gruppen hervorgerufen werden, bei denen jeweils nur ein Wasserstoffatom an ein Kohlenstoffatom gebunden ist) mit einer verringerten Hochfrequenzleistung zu unterdrücken.

Diese Aufgabe wird erfindungsgemäß dadurch gelöst, daß eine vorgegebene Zeit dt nach dem Ende der Anregung des Kohlenstoffs zunächst ein magnetischer Hochfrequenzimpuls der Dauer T und der Amplitude $B_p$ erzeugt wird, daß unmittelbar danach die Amplitude des HF-Feldes auf einen Wert $B_c$ abgesenkt wird und währenddessen das Kernresonanzsignal erfaßt wird, und daß die Parameter T, dt, Bc und Bp so gewählt sind, daß die durch die J-Kopplung bewirkte Modulation des Kernresonanzsignals gerade verschwindet.

Bei der Erfindung wirkt das Hochfrequenzmagnetfeld mit der Larmorfrequenz von Wasserstoff also in zwei Phasen auf den Untersuchungsbereich ein: In der ersten Phase mit einer größeren Amplitude und in der zweiten Phase mit einer kleinen Amplitude. die erste Phase ist kurz im Vergleich zur zweiten Phase (sie entspricht einem Hochfrequenzimpuls), und das Kernresonanzsignal wird nur während der zweiten Phase erfaßt. Es läßt sich zeigen, daß sich die Dauer des Hochfrequenzimpulses T, die Amplituden $B_p$ und $B_c$ des Hochfrequenzmagnetfeldes in diesen Phasen und der zeitliche Abstand des Hochfrequenzimpulses von der vorausgehenden Anregung der Kohlenstoffatome stets so einstellen lassen, daß die durch die J-Kopplung bewirkte Modulation des Kernresonanzsignals und damit die Dublettstruktur gerade verschwindet und an dieser Stelle nur noch eine Linie empfangen wird.

Allerdings hat diese Linie nicht die doppelte Amplitude wie die Dublettlinien, sondern eine Amplitude, die umso kleiner ist, je kleiner das Hochfrequenzmagnetfeld in der zweiten Phase im Vergleich zu der J-Kopplung ist. Bei sehr kleinen magnetischen Feldstärken $B_c$ ist die Amplitude proportional zu Bc. Diese Abhängigkeit nutzt eine Weiterbildung der Erfindung aus, die vorsieht, daß zur Unterdrückung der betreffenden CH-Gruppe im Spektrum der Wert $B_c$ Null ist. Es kann damit also eine bestimmte CH-Gruppe völlig aus dem gemessenen Spektrum ausgeblendet werden.

Die Erfindung kann u.a. dazu dienen, bestimmte CH-Gruppen, deren Larmorfrequenzen bekannt sind, zu identifizieren, indem man das erfindungsgemäß entkoppelte Spektrum mit einem nicht entkoppelten Spektrum vergleicht, wobei sich Unterschiede lediglich bei den CH-Gruppen ergeben, deren Wasserstoff-Larmorfrequenzen eingestrahlt werden.

Die Erfindung wird nachstehend anhand der Zeichnung näher erläutert. Es zeigen

Fig. 1 ein Gerät, mit dem die Erfindung durchführbar ist, in schematischer Darstellung.

Fig. 2 den zeitlichen Verlauf der Signale bei einem erfindungsgemäßen Verfahren,

Fig. 3a und b nicht entkoppelte bzw. entkoppelte Spektren und Fig. 4 eine Produktoperator-Darstellung zur Erläuterung der Wirkung der Erfindung.

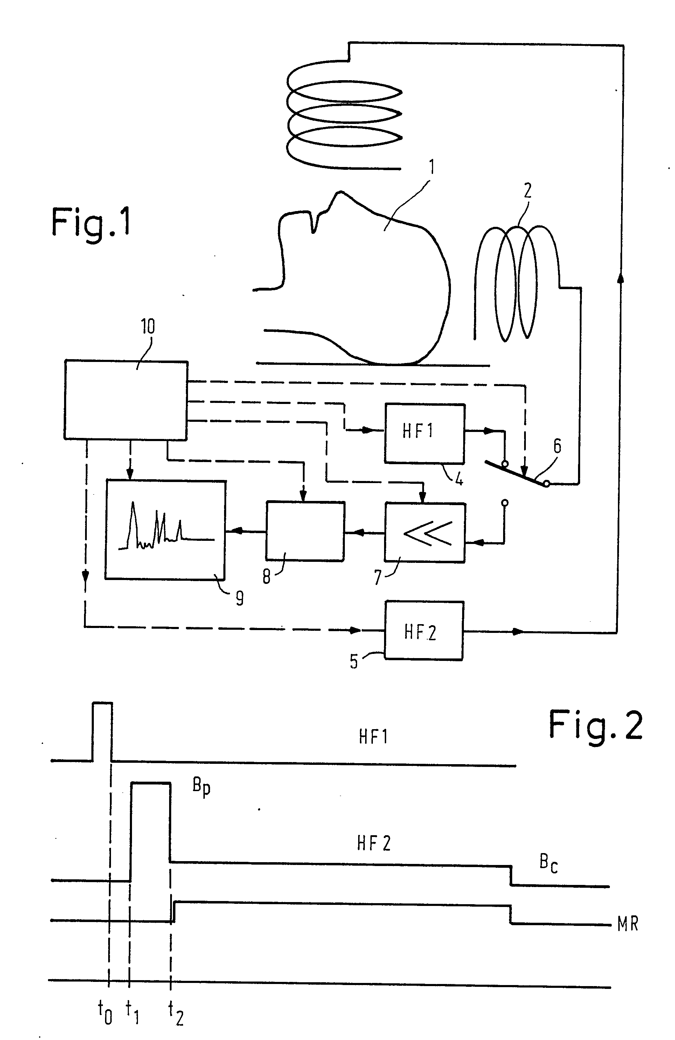

In Fig. 1 ist mit 1 ein im Untersuchungsbereich befindlicher Patient bezeichnet, der einem starken homogenen und stationären Magnetfeld ausgesetzt ist. Dieses senkrecht zur Zeichenebene verlaufende Magnetfeld wird von einem nicht näher dargestellten Magneten erzeugt. Für Zwecke der Spektroskopie beträgt seine Induktion z.B. 4 Tesla. Bei 4 Tesla beträgt die Larmorfrequenz von $^{13}$C-Kernen etwa 42,8 MHz, während die Larmorfrequenz von Protonen rund 170 MHz beträgt.

Das Gerät umfaßt einen ersten Hochfrequenzerzeuger 4, der Schwingungen mit der Larmorfrequenz des Kohlenstoffs erzeugt und über einen Schalter 6 mit einer ersten Hochfrequenzspule 2 verbunden ist, die auf diese Frequenz abgestimmt ist und auf den Untersuchungsbereich einwirkt. Ein zweiter Hochfrequenzerzeuger 5 erzeugt Schwingungen mit der Larmorfrequenz der (Wasserstoff-)Protonen und ist mit einer Hochfrequenzspule 3 verbunden, die ebenfalls im Untersuchungsbereich ein zu dem stationären Magnetfeld senkrecht verlaufendes Magnetfeld erzeugt.

Die im Untersuchungsbereich bei der Larmorfrequenz von Kohlenstoff entstehenden Kernresonanzsignale werden von der Spule 2 aufgenommen und über den Schalter 6 einem Empfänger 7 zugeführt. An den Ausgang des Empfängers 7 ist eine Auswerteschaltung 8 angeschlossen, die aus dem empfangenen Kernresonanzsignal mittels Fouriertransformation das Spektrum erzeugt, das auf einer geeigneten Wiedergabeeinheit 9 wiedergegeben werden kann. Die Komponenten 4..9 werden von einer Steuereinheit 10 gesteuert, die einen geeigneten Mikrocomputer oder dergleichen umfassen kann.

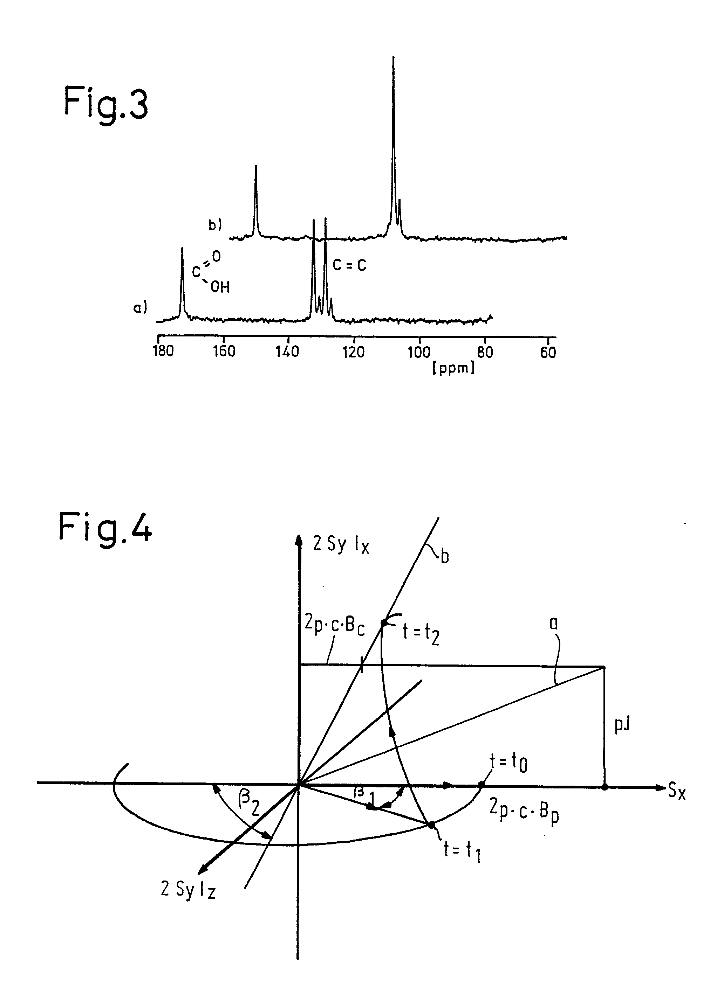

Aus Fig. 2 ergibt sich, wann die beiden Hochfrequenzerzeuger und der Empfänger wirksam sind. Zunächst wird mit dem Hochfrequenzerzeuger 4, d.h. auf der Larmorfrequenz des Kohlenstoffs, ein kurzer Hochfrequenzimpuls erzeugt, vorzugsweise ein 90°-Hochfrequenzimpuls, der zur Zeit $t_0$ endet (erste Zeile von Fig. 2). Zur Zeit $t_2$ - oder kurze Zeit danach - wird das von diesem Hochfrequenzimpuls erzeugte Kernresonanzsignal, dessen Frequenz bei der Larmorfrequenz von Kohlenstoff liegt, empfangen und abgetastet (dritte Zele von Fig. 2), und zwar während eines Zeitraums, der sehr groß ist im Vergleich zu der Dauer des dieses Kernresonanzsignal erzeugenden Hochfrequenzimpulses und beispielsweise 200 ms dauert. Wenn während dieses Zeitraums oder davor der zweite Hochfrequenzerzeuger 5 nicht aktiviert würde, würde sich das in Fig. 3a dargestellte (nicht entkoppelte) Kohlenstoffspektrum ergeben. Man erkennt bei etwa 130 ppm deutlich eine Doppellinie (Dublett), die in einer ungesättigten Fettsäure aus dem Abschnitt -CH = CH-herrührt. Die Larmorfrequenz der darin enthaltenen Protonen weicht von den Larmorfrequenzen der in anderen CH-Gruppen gebundenen Protonen ab und ist daher für diesen Abschnitt charakteristisch.

Um die Doublettstruktur dieses Abschnitts zu unterdrücken, wird nach dem Zeitpunkt $t_0$ der zweite Hochfrequenzerzeuger 5 aktiviert, und zwar bei einer Frequenz, die der zuvor erläuterten charakteristischen Larmorfrequenz der Protonen in dem betreffenden Abschnitt entspricht. Dabei wird die Amplitude des magnetischen Hochfrequenzfeldet zur Zeit $t_1$ auf einen relativ großen Wert Bp angehoben und zur Zeit $t_2$ auf einen relativ kleinen Wert $B_c$ abgesekt. Der Zeitraum $t_1$-$t_2$ ist dabei im Vergleich zu dem Zeitraum, währenddessen das Kernresonanzsignal erfaßt wird, wesentlich kürzer als in Fig. 2 dargestellt. Die Einstrahlung der Protonenlarmorfrequenz mit der Amplitude $B_c$, sobald die Erfassung des Kernresonanzsignals endet.

Es läßt sich zeigen, daß bei geeigneter Wahl von Bp, Bc, von $T = t_1$-$t_2$ und von $dt = t_1$-$t_0$ die durch die J-Kopplung bewirkte Modulation des Kernresonanzsignals verschwindet, so daß das Spektrum an der zugehörigen Stelle (vergl. Fig. 3b) nur eine einzige Linie zeigt. Dies wird im folgenden näher erläutert, wobei auf Fig. 4 bezug genommen wird, die die Auswirkungen der verschiedenen Maßnahmen in einer Produktoperatordarstellung zeigt (vergl. Progress in NMR-Spectroscopy, Vol. 16, pp 163-192, 1983). Der Spin des $^{13}$C-Atomkerns ist dabei mit S und der des $^1$H-Atomkerns mit I bezeichnet.

Zur Zeit $t = t_0$ verläuft die Kernmagnetisierung in Richtung $S_x$ - wenn der Impuls mit der Kohlenstoff-Larmorfrequenz den Kernmagnetisierungssektor um 90° um die y-Achse kippt. Unter dem Einfluß der J-Kopplung ergibt sich eine Rotation in Richtung auf den Zustand $2S_yI_z$, wobei der Zustand $2S_yI_y$ unverändert bleibt. Der zur Zeit $t = t_1$ durchlaufene Winkel $\beta_1$ genügt dabei der Gleichung

$\beta_1 = pJ(t_1 - t_0).$ (1)

Dabei ist p die Kreiskonstante bzw. die Ludolphsche Zahl (3,14159...) und J die Stärke der J-Kopplung.

Zur Zeit $t_1$ wird das Hochfrequenzfeld $B_p$ mit der Protonen-Larmorfrequenz wirksam. Dieses Feld dreht - für sich allein genommen - den Produktoperator zwischen den Zuständen $2 S_yI_z$ und $2 S_yI_x$ - falls die Protonenspins um eine y-Referenzachse gekippt werden - und beeinflußt den Zustand Sx nicht. Durch die kombinierte Wirkung dieses Hochfrequenzfeldes und der J-Kopplung ergibt sich eine Rotation des Produktoperators auf dem Mantel eines Kegels, dessen Spitze im Koordinatenursprung liegt und dessen Symmetrieachse a durch die Größe des Feldes $B_p$ und die J-Kopplung bestimmt ist. Dabei befindet sich zur Zeit $t = t_2$ der Produktoperator gerade auf einer Geraden b durch den Koordinatenursprung, die mit $S_x$ den Winkel $\beta_2$ einschließt und in der durch $2S_yI_x$ und durch $S_x$ definierten Ebene liegt.

Zur Zeit $t = t_2$ wird die Amplitude $B_p$ auf einen Wert $B_c$ herabgesetzt, der zur Stärke der J-Kopplung im gleichen Verhältnis steht wie der Anteil $S_x$ zum Anteil $2S_yI_x$. Es gilt somit die Gleichung

$$\beta_2 = \arctan(J/2cB_c). \quad (2)$$

Dabei ist c das gyromagnetische Verhältnis (für Protonen ca. 42,58 MHz/T) und arc tan ( ) die Umkehrfunktion der Tangensfunktion, d.h. tan (arctan ( )) = ( ). In diesem Fall bleibt die Kernmagnetisierung unter dem Einfluß des Feldes $B_c$ und der J-Kopplung fest, d.h. das beobachtete Signal weist keine Modulation durch die J-Kopplung mehr auf. Im entkoppelten Spektrum erscheint somit anstelle der Doppellinie eine einfache Linie eine einfache Linie.

Wenn der zeitliche Abstand $dt = t_1 - t_0$ vorgegeben ist und $B_c$ entsprechend Gleichung (2) gewählt ist, dann ergibt sich die Amplitude des magnetischen Hochfrequenzfeldes $B_p$ im Intervall $t_2 - t_1$ zu

$$B_p = J/2c * \sin\beta_2/(\cos\beta_1 - \cos\beta_2) \quad (3)$$

Der Winkel $\beta_3$, den der die Kernmagnetisierung kennzeichnende Produktvektor im Zeitintervall $t_2 - t_1$ beschreibt, ist dann gegeben durch

$$\beta_3 = 2 \arctan(( (\cos\beta_1 - \cos\beta_2)^2 + \sin^2\beta_2)^{-0,5}/\sin\beta_1) \quad (4)$$

Für die Dauer T bzw. das Zeitintervall $t_2 - t_1$ folgt daraus

$$T = t_2 - t_1 = \beta_3 / ((2pcBp)^2 + (pJ)^2)^{0,5} \quad (5)$$

Wenn somit die Parameter $B_c$, $B_p$ dt und T so gewählt sind, daß die Gleichungen 1 bis 5 für eine bestimmte CH-Gruppe erfüllt sind, geht die dafür im nicht entkoppelten Spektrum auftretende Doppellinie in eine einzige Linie über. Allerdings entspricht die Amplitude dieser Linie nicht der Summe der Amplituden der Doppellinien, sondern ist um einen Faktor $\cos\beta_2$ niedriger als dieser Wert. In der Auswerteeinheit 8 muß die entsprechende Frequenzkomponente daher mit dem Wert $\beta_2$ multipliziert werden.

Der Wert $B_c$ muß so gewählt werden, daß die zulässige Hochfrequenzbelastung nicht überschritten wird; man kann ihn jedoch auch zu Null wählen. In diesem Fall wird $\beta_2 = 90°$, so daß die Amplitude der anstelle der Doppellinie erscheinenden Linie wegen $\cos\beta_2 = 0$ zu Null wird. In diesem Fall vereinfacht sich Gleichung (3) zu

$$Bp = J/(2c * \cos\beta_1). \quad (6)$$

- Das bedeutet also, daß sich das von einer bestimmten CH-Gruppe herrührende Kernresonanzsignal (bei der Larmorfrequenz von Kohlenstoff) vollständig unterdrücken läßt, wenn nach der Kohlenstoffanregung und vor der Erfassung des Kernresonanzsignals auf den Untersuchungsbereich ein Hochfrequenzimpuls mit der Larmorfrequenz der in der CH-Gruppe enthaltenden Protonen während einer durch Gleichung (5) vorgegebenen Dauer T eingeschaltet wird. Es lassen sich also auf diese Weise gezielt Linien aus dem Spektrum ausblenden. Das erfindungsgemäße Verfahren beeinflußt die Spektrallinien nur solcher CH-Gruppen, deren Protonen-Larmorfrequenz mit der vom zweiten Hochfrequenzerzeuger 5 erzeugten Frequenz identisch ist und deren J-Kopplung den in den Gleichungen (2) und (3) zugrundegelegten Wert J hat. In der Regel erfüllt nur eine CH-Gruppe diese Bedingungen, was zur Identifizierung dieser CH-Gruppe benutzt werden kann. Wenn die Lage der Doppellinie dieser Gruppe im Kohlenstoffspektrum der genaue Wert der Protonenlarmorfrequenz und die J-Kopplung bekannt sind. Der Hochfrequenzerzeuger 5 wird dann auf die entsprechende Protonenlarmorfrequenz eingestellt, wobei die übrigen Parameter aus den Gleichungen 1 bis 5 folgen. Ergibt sich dann an der Stelle, an der im nicht entkoppelten Kohlenstoffspektrum die Doppellinie der CH-Gruppe auftritt, im entkoppelten Spektrum eine Veränderung, dann ist damit die betreffende CH-Gruppe identifiziert.

**Ansprüche**

1. Kernresonanz-Spektroskopieverfahren, bei dem zur Unterdrückung der Doublettstruktur von wenigstens eine CH-Gruppe in Kohlenstoff und Wasserstoff enthaltenden Verbindungen ein erstes magnetisches Hochfrequenzfeld mit der Larmorfrequenz des Kohlenstoffs erzeugt wird, wonach ein zweites magnetisches Hochfrequenzfeld mit der Larmorfrequenz des Wasserstoffs in der betreffenden CH-Gruppe auf den Untersuchungsbereich einwirkt, und das erzeugte Kernresonanzsignal erfaßt wird,
dadurch gekennzeichnet, daß eine vorgegebene Zeit dt nach dem Ende der Anregung des Kohlenstoffs zunächst ein magnetischer Hochfrequenzimpuls der Dauer T und der Amplitude $B_p$ erzeugt wird, daß unmittelbar danach die Amplitude des HF-Feldes auf einen Wert $B_c$ abgesenkt wird und währenddessen das Kernresonanzsignal erfaßt wird, und daß die Parameter T, dt, Bc und Bp so gewählt sind, daß die durch die J-Kopplung bewirkte Modulation des Kernresonanzsignals gerade verschwindet.

2. Verfahren nach Anspruch 1,
dadurch gekennzeichnet, daß zur Unterdrückung der betreffenden CH-Gruppe im Spektrum der Wert $B_c$ Null ist.

3. Anordnung zur Durchführung des Verfahrens nach Anspruch 1 mit einer ersten Spulenanordnung zum Erzeugen von magnetischen Hochfrequenzfeldern und zum Empfangen von Kernresonanzsignalen bei der Larmorfrequenz von Kohlenstoff und mit einer zweiten Spulenanordnung zum Erzeugen von magnetischen Hochfrequenzfeldern bei der Larmorfrequenz des Wasserstoffs, einem ersten und einem zweiten Hochfrequenz erzeuger zur Speisung der Hochfrequenzspulenanordnungen sowie mit einem Empfänger zum Empfangen von Kernresonanzsignalen bei der Larmorfrequenz des Kohlenstoffs und mit einer Steuereinheit zum Steuern des Hochfrequenzerzeugers und Empfängers, dadurch gekennzeichnet, daß die Steuereinheit die Hochfrequenzerzeuger (4,5) und den Empfänger (7) so steuert, daß zunächst ein erster Hochfrequenzimpuls von der ersten Hochfrequenzspulenanordnung (4), danach ein zweiter Hochfrequenzimpuls von der zweiten Hochfrequenzspulenanordnung (5) erzeugt wird, wonach die Amplitude des von der zweiten Hochfrequenzspulenanordnung erzeugten Magnetfeldes herabgesetzt wird und der Empfänger aktiviert wird.

Fig.1

Fig.2

1-II-PHD 88-228

# Fig.3

# Fig.4

2-Ⅱ-PHD 88-228